# EUROPEAN PATENT APPLICATION

(11) **EP 4 386 866 A1**
(43) Date of publication of application: **19.06.2024**
(21) Application number: 23203938.8
(22) Date of filing: 17.10.2023
(51) Int. Cl.: H01L 31/0224

(54) **AN ELECTRODE STRUCTURE, A BACK-CONTACT SOLAR CELL, A CELL ASSEMBLY, AND A PHOTOVOLTAIC SYSTEM**

(30) Priority: 12.12.2022 CN 202211588511
(71) Applicant: Solarlab Aiko Europe GmbH, 79110 Freiburg (DE)
(72) Inventor: CHEN, Gang, Yiwu (CN); WANG, Yongqian, Yiwu (CN); YANG, Xinqiang, Yiwu (CN)
(74) Representative: LLR

(57) **Abstract**

The present application applies to the field of solar cell technology and provides an electrode structure, a back-contact solar cell, a cell assembly, and a photovoltaic system; a plurality of first secondary gates of the electrode structure include a first collection gate line and a first confluence gate line; the first primary gate includes a first edge primary gate disposed on one side near the first edge of the back-contact solar cell, and one end of the first confluence gate line is connected to the first edge primary gate, the other end running through the first discontinuous zone on the second primary gate adjacent to the first edge primary gate is connected to the first primary gate adjacent to the first edge primary gate. In this way, through the first confluence gate line, the current collected by the first edge primary gates in the edge area can be directly converged with the first primary gates adjacent to the first edge primary gates, without welding on the first edge primary gates, which can avoid stress concentration in the welding process, improve the yield and reliability of assembly, while providing a relatively high photoelectric conversion efficiency.

## Description

### Priority Information

The present application requests the priority and interest of the patent application No. 202211588511.0 submitted to the China National Intellectual Property Administration on December 12, 2022, and its full text is incorporated herein by reference.

### Technical Field

The present application relates to the field of solar cell technology, in particular to an electrode structure, a back-contact solar cell, a cell assembly, and a photovoltaic system.

### Background Art

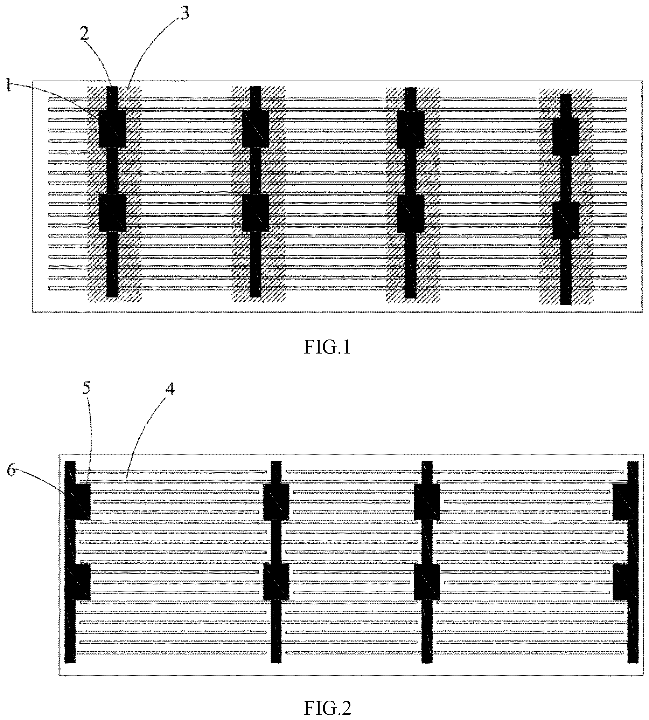

Back-contact solar cell is a type of cell with both the emitter and base contact electrodes disposed on its back (non light-receiving face). The cell's light-receiving face which is not obstructed by any metal electrodes effectively increases its short-circuit current. As shown in FIG. 1, in related technologies, in order to converge the fine gates of same polarity, generally insulating adhesive 3 is printed on those of opposite polarity to form insulation, with others of same polarity exposed, and solder joint 1 and busbar 2 are then printed to make the fine gates of same polarity in contact to converge those of different polarity. In such a case, however, insulating adhesive 3 cannot withstand high temperatures, while solder joint 1 and busbar 2 are formed by post-printing, and only low-temperature paste can be selected for them, which means increased costs and reliability issues. Moreover, insulating adhesive 3 is about 30um high for a good insulation, solder j oint 1 and busbar 2 are required to be higher than 30um to avoid wire breakage, which will result in an increasing paste consumption and higher costs. In addition, poor adhesion may occur between insulating adhesive 3 and some of the paste.

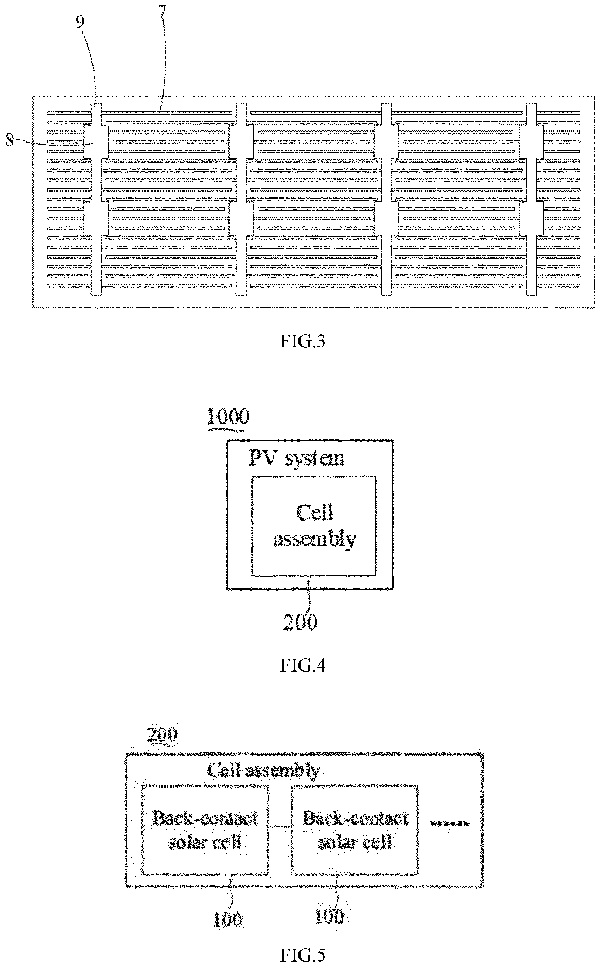

The electrode pattern of the back-contact solar cell can be designed as shown in FIG. 2 and 3 to address the problem in FIG. 1. In FIG.2, the fine gate 4 is disconnected at the opposite solder joint 5 and busbar 6 which are located at the extreme edge of the silicon wafer. During the assembly manufacturing, as a result, the solder strip also needs to cover the edge of silicon wafer. A large number of micro cracks at the edge of silicon wafer will easily cause stress concentration during the welding process of solder strip, leading to cracking, reduced component yield and reliability.

In FIG. 3, the fine gate 7 is disconnected at the opposite solder joint 8 and busbar 9. The solder joint 8 and busbar 9 on the outside are at a certain distance from the extreme edge of silicon wafer, and are provided with the same polarity on the periphery. Although the design in FIG. 3 solves the problems in FIG. 2, the photogenerated electron holes need to diffuse to the opposite region before an effective collection is realized. For FIG. 3, the photogenerated electron holes in the outer edge region need to span a distance of mm or even cm level before reaching the opposite region. The composite loss during the long-distance diffusion will cause a decrease in short-circuit current and increase string resistance, resulting in a loss of fill factor and very poor photoelectric conversion performance.
Designing an electrode structure for back-contact solar cells to address the above problems has therefore always been one of the key research issues for person skilled in the art.

### Summary of the Invention

The present application provides an electrode structure, a back-contact solar cell, a cell assembly, and a photovoltaic system, in order to address the technical problems of low reliability and poor photoelectric conversion performance of existing back-contact solar cells.

The present application is implemented in such a way that the electrode structure of the embodiment is used for a back-contact solar cell that includes a first polar region and a second polar region which are alternatively arranged, and the electrode structure includes:
a plurality of first secondary gates and a plurality of second secondary gates, which are alternately spaced, wherein the first secondary gate electrode is used to collect the current in the first polar region, and the second secondary gate electrode is used to collect the current in the second polar region; and
a plurality of first primary gates and a plurality of second primary gates, which are alternately spaced, wherein the first and the second primary gates are arranged in a direction different from the first and the second secondary gates; the first primary gates are connected to the first secondary gate, and the second primary gates are connected to the second secondary gates;
a plurality of first secondary gates include a first collection gate line and a first confluence gate line, wherein the first collection gate lines are disconnected at the second primary gates, and a plurality of first primary gates include a first edge primary gates located on the side near the first edge of the back-contact solar cell, and the first discontinuous zone formed by the adjacent second primary gates of the first edge primary gates; one end of the first confluence gate line is connected to the first edge primary gate, and the other end running through the first discontinuous zone is connected to the first primary gate adjacent to the first edge primary gate;
the first edge primary gate is not provided with solder joints and/or not used for welding;
the first edge primary gate is located at the first edge.

The present application also provides a back-contact solar cell, including an electrode structure, as described in any of the above items, that is disposed on the shady face of the back-contact solar cell.

The present application also provides a cell assembly, including the back-contact solar cell mentioned above.

The present application also provides a photovoltaic system, including the aforementioned cell assembly.

In the electrode structure, back-contact solar cell, cell assembly, and photovoltaic system of the present embodiment, the first collection gate line of the first secondary gate is disconnected at the second primary gate, and the first edge primary gate of the first primary gate is connected to the first collection gate line in the first secondary gate to collect the current in the first polar region near the first edge through the first collection gate line, and the first confluence gate line passes through the first discontinuous zone on the second primary gate adjacent to the first edge primary gate to connect the first edge primary gate as well as the first primary gate adjacent to the first edge primary gate. The current collected by the first edge primary gate can be transmitted for convergence and collection purpose through the first confluence gate line to the first primary gate adjacent to the first edge primary gate. In this way, the current in the edge area collected by the first edge primary gate which is disposed on the side near the first edge of the back-contact solar cell, can directly converge through the first confluence gate line, and the first primary gate adjacent to the first edge primary gate, dispense with any welding on the first edge primary gate, which can avoid stress concentration during welding and improve the yield and reliability of assembly. Meanwhile, the photogenerated electron holes near the first edge can, without spanning a long distance, reach the opposite region to collect the current and fully ensures a high photoelectric conversion.

A part of the additional aspects and advantages of the present application will be provided in the following, and some will become apparent or may be learned through the practice of the application.

### Brief Description of the Drawings

FIG. 1 is a schematic diagram of the graphic design of the first electrode in the prior art;
FIG. 2 is a schematic diagram of the graphic design of the second electrode in the prior art;
FIG. 3 is a schematic diagram of the graphic design of the third electrode in the prior art;
FIG. 4 is a schematic diagram of the module of photovoltaic system provided in the embodiment of the present application;
FIG. 5 is a schematic diagram of the module of the cell assembly provided in the embodiment of the present application;
FIG. 6 is a structural schematic diagram of the electrode structure provided in the embodiment of the present application;
FIG. 7 is another structural schematic diagram of the electrode structure provided in the embodiment of the present application;
FIG. 8 is yet another structural schematic diagram of the electrode structure provided in the embodiment of the present application;
FIG. 9 is still another structural schematic diagram of the electrode structure provided in the embodiment of the present application;
FIG. 10 is still another structural schematic diagram of the electrode structure provided in the embodiment of the present application;
FIG. 11 is still another structural schematic diagram of the electrode structure provided in the embodiment of the present application;
FIG. 12 is still another structural schematic diagram of the electrode structure provided in the embodiment of the present application;
FIG. 13 is still another structural schematic diagram of the electrode structure provided in the embodiment of the present application;
FIG. 14 is still another structural schematic diagram of the electrode structure provided in the embodiment of the present application.

### Detailed Description of Embodiments

In order to make the object, technical schemes and advantages of the present application clearer, the present application will be further described in detail with reference to the accompanying drawings and embodiments. The examples of the embodiments are shown in the accompanying drawings, where the same or similar labels throughout represent the same or similar elements or the elements with the same or similar functions. The embodiments described below with reference to the accompanying drawings are exemplary and are only intended to explain the present application and cannot be understood to limit the present application. In addition, it should be understood that the specific embodiments described here are intended for illustrating rather than limiting the present application.

In the description of the present application, it should be understood that, the terms "up", "down", "left", "right", "horizontal", and "vertical" indicate the orientation or position relationship based on the orientation or position relationship shown in the attached drawings, only for the convenience of simple description of the present application, rather than indicating or implying that the devices or elements referred to must have a specific orientation, be constructed and operated in a specific orientation, and therefore cannot be understood as a limitation on the present application.

In addition, the terms like "first" and "second" are only for illustrative purposes and cannot be understood as indicating or implying relative importance or the number of technical features referred to. Therefore, the features defined with "first" and "second" may explicitly or implicitly include at least one or a plurality of features. In the description of the present application, the meanings of "a plurality of', "pieces of", and "a number of" refer to two or more, unless otherwise specified.

In the present application, unless otherwise specified and limited, the first feature "above" or "below" the second feature may include direct contact between the first and second features, or direct contact between the first and second features through additional features between them. Moreover, the first feature "over", "above" and "on" the second feature includes the first feature being directly above and diagonally above the second feature, or simply indicating that the first feature is horizontally higher than the second feature. The first feature "below", "beneath", and "under" the second feature includes the first feature directly below and diagonally below the second feature, or simply indicating that the horizontal height of the first feature is less than that of the second feature.

The following disclosure provides many different embodiments, or examples, to implement different features in the present application. The components and arrangements of specific examples are described below to simplify the disclosure of the present application. These are, of course, merely examples that are not intended to limit the present application. In addition, the present application may repeat reference numerals and/or letters in the various examples. This repetition is for the purpose of simplicity and clarity and does not in itself dictate a relationship between the various embodiments and/or configurations discussed. In further, the application provides examples of various specific processes and materials, but person of ordinary skill in the art can be aware of the application of other processes and/or the usage scenarios of other materials.

In the present application, the current in the edge area collected by the first edge primary gate which is disposed on the side near the first edge of the back-contact solar cell, can directly converge through the first confluence gate line, and the first primary gate adjacent to the first edge primary gate, dispense with any welding on the first edge primary gate, which can avoid stress concentration during welding and improve the yield and reliability of assembly. Meanwhile, the photogenerated electron holes near the first edge can, without spanning a long distance, reach the opposite region to collect the current and fully ensures a high photoelectric conversion.

### Embodiment 1

Referring to FIG. 4 to 5, the photovoltaic system 1000 in the embodiment of the present application may include the cell assembly 200, which in further include a plurality of back-contact solar cells 100 in the embodiment of the present application.

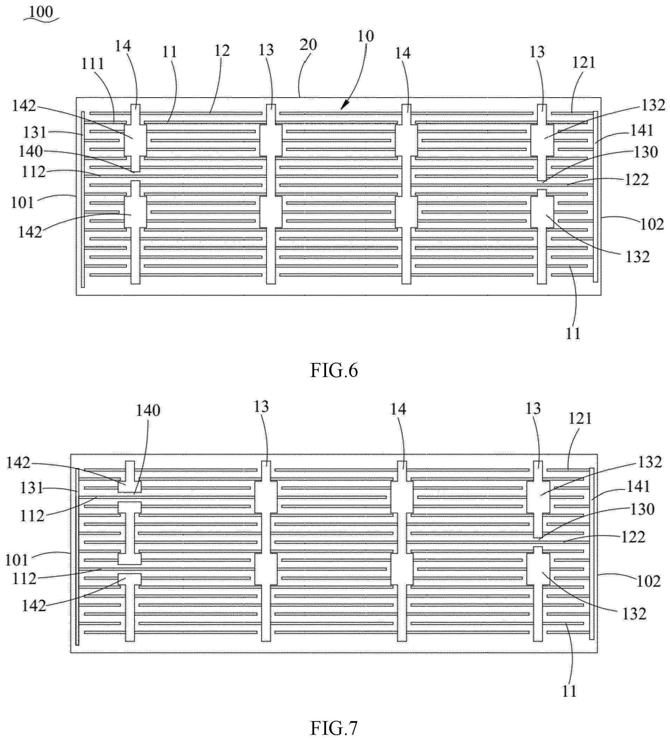

Referring to FIG.6, the back-contact solar cell 100 in the embodiment of the present application can include a substrate 20 and an electrode structure 10 in the embodiment of the present application. The substrate 20 can be a silicon wafer, and the back of the substrate 20 is alternatively provided with the first polar region and the second polar region having mutually opposite polarities. The first polar region and the second polar region, for example, can be a P-type doped region and an N-type doped region, respectively; for another instance, the first polar region and the second polar region can be an N-type doped region and a P-type doped region, respectively, which are not limited here.

Referring to FIG. 6, the electrode structure 10 in the embodiment of the present application can be disposed on the shady face of the back-contact solar cell 100, and the electrode structure 10 can include a plurality of the first gates 11 and a plurality of the second gates 12, which are alternately spaced, as well as a plurality of the first gates 13 and a plurality of the second gates 14, which are alternately spaced.

The first secondary gate 11 and the second secondary gate 12 are respectively used to collect the current in the first polar region and second polar region, that is, the first secondary gate 11 and the second secondary gate 12 can correspond to the first polar region and second polar region, respectively.

The first primary gate 13 and the second primary gate 14 are arranged in a direction different from that of the first secondary gate 11 and the second secondary gate 12. The first primary gate 13 and the second primary gate 14 are connected to the first secondary gate 11 and the second secondary gate 12, respectively, that is, the first primary gate 13 can be used to accumulate the current collected by the first secondary gate 11, and the second primary gate 14 can be used to accumulate the current collected by the second secondary gate 12.

As shown in FIG. 6, a plurality of first secondary gates 11 include a first collection gate line 111 and a first confluence gate line 112; the first collection gate line 111 is disconnected at the second primary gate 14, and a plurality of first primary gates 13 include the first edge primary gate 131 (i.e. the leftmost first primary gate 13 in FIG. 6) which, located on one side of the first edge 101 near the back-contact solar cell 100, forms a first discontinuous zone 140 together with the second primary gate 14 adjacent to the first edge primary gate 131 (i.e. the first second primary gate 14 from left to right in FIG. 6). One end of the first confluence gate line 112 is connected to the first edge primary gate 131, and the other end running through the first discontinuous zone 140 is connected to the first primary gate 13 adjacent to the first edge primary gate 131 (i.e. the second first primary gate 13 from left to right in FIG. 6), and the position where the first confluence gate line 112 passes through the first discontinuous zone 140 is insulated and isolated from the second primary gate 14. In the electrode structure 10, back-contact solar cell 100, cell assembly 200, and photovoltaic system 1000 of the present embodiment, the first collection gate line 111 of the first secondary gate 11 is disconnected at the second primary gate 14, and the first edge primary gate 131 of the first primary gate 13 is connected to the first collection gate line 111 in the first secondary gate 11 to collect the current in the first polar region near the first edge 101 through the first collection gate line 11, and the first confluence gate line 112 passes through the first discontinuous zone 140 on the second primary gate 14 adjacent to the first edge primary gate 131 to connect the first edge primary gate 131 as well as the first primary gate 13 adjacent to the first edge primary gate 131. The current collected by the first edge primary gate 131 can be transmitted for convergence and collection purpose through the first confluence gate line 112 to the first primary gate 13 adjacent to the first edge primary gate 131. In this way, compared to the electrode pattern design in FIG. 2 of the prior art, the current in the edge area collected by the first edge primary gate 131 in the present application which is disposed on the side near the first edge 101 of the back-contact solar cell 100, can directly converge through the first confluence gate line 112, and the first primary gate 13 adjacent to the first edge primary gate 131, dispense with any welding on the first edge primary gate 131, which can avoid stress concentration during welding and improve the yield and reliability of assembly. Compared to the graphic design of electrode in FIG. 3 of the prior art, meanwhile, the photogenerated electron holes near the first edge 101 can, without spanning a long distance, reach the opposite region to collect the current and fully ensures a high photoelectric conversion.

Specifically, in the embodiment of the present application, the first and second polar regions have opposite polarities, so do the first secondary gate and the second secondary gate 11 & 12. For example, the first secondary gate 11, a positive secondary gate line, is used to collect positive current in the positive electrode area, while the second secondary gate 12, a negative secondary gate line, is used to collect negative current in the negative electrode area; alternatively, the first secondary gate 11, a negative secondary gate electrode, is used to collect negative current in the negative electrode area, and the second secondary gate 12, a positive gate electrode, is used to collect positive current in the positive electrode area. The positive secondary gate line and the negative secondary gate line are respectively disposed in the P-type doped region and N-type doped region of the back-contact solar cell 100.

As shown in FIG. 6, in the embodiment shown in FIG. 6, the first and second primary gates 11 & 12 are alternatively arranged in the vertical direction, and are both horizontal to the upper and lower edge lines of the back-contact solar cell 100, correspondingly, the first and second polar regions are also alternately arranged in a vertical direction.

The first primary gate 13 and the second primary gate 14 can be, in a horizontal direction, vertically arranged alternately with the first secondary gate 11 and the second secondary gate 12. Referring to FIG. 6, for example, the first secondary gate 11 and the second secondary gate 12 are alternately arranged in the vertical direction, and are both horizontal to the upper and lower edge lines of the back-contact solar cell 100, while the first primary gate 13 and the second primary gate 14 are alternately arranged in the horizontal direction, and are both horizontal to the left and right edge lines of the back-contact solar cell 100.

In the embodiment of the present application, the back-contact solar cell 100 can be substantially rectangular, and the term "substantially rectangular" means that the back-contact solar cell 100 can be a square, rectangular, or rectangular shape with standard, cut, or rounded corners, which are set according to actual production needs and are not limited here. In addition, the number of the first secondary gate and the second secondary gate 11 & 12 is determined based on the actual area of the back-contact solar cell 100, the width of and the distance between them, which are not limited here.

In the embodiment of the present application, "the first edge primary gate 131 forms a first discontinuous zone 130" means that the first edge primary gate 131, a discontinuous structure, is separated at the first discontinuous zone 130, that is, the first edge primary gate 131 is separated into at least two parts by the first discontinuous zone 130.

In the embodiment shown in FIG. 6, "first edge 101" refers to the left edge in FIG. 6, and "the first edge primary gate 131 is located on the side near the first edge 101" means that the first edge primary gate 131 is the leftmost first primary gate 13 in FIG. 6, that is, the first primary gate 13 near the first edge 101 can be a certain distance from the first edge 101 of the back-contact solar cell 100, or can also be the first edge 101 that is directly disposed on the back-contact solar cell 100 (i.e. the left edge in FIG. 6), which are subject to no restrictions here.

In further, as shown in FIG. 6, it can be understood that in the embodiment of the present application, the first secondary gate 11 and the second secondary gate 12 are alternatively disposed between the first edge primary gate 131 and the second primary gate 14 adjacent to the first edge primary gate 131. The first collection gate line 111 in the first secondary gate 11 between the two is connected to the first edge primary gate 131, and the second secondary gate 12 is connected to the second primary gate 14 adjacent to the first edge primary gate 131, and the first confluence gate line 112 passing through the first discontinuous zone 140 is connected to the first primary gate 13 adjacent to the first edge primary gate 131.

The first edge primary gate 131 can converge the current collected by the first collection gate line 111 between the first edge primary gate 131 and the second primary gate 14 adjacent to the first edge primary gate 131, and the current then flows through the first collection gate line 112 to the first primary gate 13 adjacent to the first edge primary gate 131, so that the current generated in the first polar region of the edge region near the first edge 101 is collected and converged, without welding on the first edge primary gate 131, which avoids the occurrence of cracks on the edge of the back-contact solar cell 100 during the welding.

In further, in the embodiment of the present application, the first and the second gates 11 & 12 may be aluminum gate lines, silver gate lines, copper gate lines, or silver plated copper gate lines, which are subject to no restrictions here.

It can be understood that in the embodiment of the present application, the first and the second gates 11 & 12 can be gate lines of the same or different metals, for example, aluminum gate lines are selected for both the first and second gates11 & 12; alternatively, aluminum gate lines and silver gate lines are selected for the first gate 11 and the second gate 12, respectively.

If the first or second gates 11 or 12 are aluminum or silver gate lines, aluminum or silver gate lines can be printed onto the doped area of the back-contact solar cell 100 through screen printing; if the first or second gates 11 or 12 are copper gate lines, copper gate lines can be plated on the doped area of the back-contact solar cell 100 through electroplating or evaporation.

In the embodiment of the present application, of course, copper, silver, aluminum, or silver coated copper gate lines can also be used for the first primary gate 13 and the second primary gate 14, which are not subject to restrictions here. It can be understood that in the process of forming the first edge primary gate 131, a screen plate can be used to cover the position corresponding to the first discontinuous zone 130, and the first edge primary gate 131 with a first discontinuous zone 130 can be formed through printing or electroplating and evaporation.

In addition, in a preferred embodiment, since the first confluence gate line 112 is connected to the first edge primary gate 131 and the first primary gate 13 adjacent to the first edge primary gate 131 to converge the first edge primary gate 131 and the adjacent first primary gate 13, the first confluence gate lines 112 may preferably be copper gate lines with smaller current loss in order to reduce the losses during the convergence, and the remaining gate lines are not limited here.

In the embodiment of the present application, a plurality of back-contact solar cells 100 in the cell assembly 200 can be sequentially connected in series to form a cell string. Each cell string can be connected in series, in parallel, or in combination, to achieve convergent current output. For example, welding strips can be used to connect cells, and a busbar can be used to connect cell strings. In the present application, for example, except for the first edge primary gate 131 and the undermentioned second edge primary gate 141, all other primary gates can be welded with welding strips to connect various cells.

It can be understood that in the embodiment of the present application, the back-contact cell assembly 200 may also include a metal frame, a backplate, photovoltaic glass, and an adhesive film (not shown in the figure). The adhesive film can serve as a fill between the front of the back-contact solar cell 100 and the photovoltaic glass, the back and the backplate, as well as adjacent cells. The filler can be a transparent colloid with good transparency and aging resistance. The adhesive film, for example, can be EVA or POE film, and can be selected according to the actual situation, which are not subject to restrictions here.

Photovoltaic glass that covers the adhesive film on the front of the back-contact solar cell 100 can be the ultra white glass having high transmittance and transparency, and excellent physical, mechanical and optical properties. Ultra white glass, for example, has a transmittance of over 92% and can, as far as possible, protect the back-contact solar cell 100 without affecting its efficiency. Meanwhile, the adhesive film can bond the photovoltaic glass and the back-contact solar cell 100 together, and the use of adhesive film can seal and insulate the back-contact solar cell 100 against water and moisture.

The backplate, which is attached to the adhesive film on the back of the back-contact solar cell 100, can protect and support the back-contact solar cell 100, and have reliable insulation, and water and aging resistance. a plurality of backplates, usually tempered glass, organic glass, aluminum alloy TPT composite adhesive film, etc., can be selected specifically according to the specific situation, which are not subject to restrictions here. The overall structure composed of the backplate, back-contact solar cell 100, adhesive film, and photovoltaic glass can be disposed on a metal frame, and the metal frame serves as the main external support structure for the entire back-contact cell assembly 200 and provides stable support and installation for the back-contact cell assembly 200. The back-contact cell assembly 200, for example, can be installed in the desired position through the metal frame.

In further, in this embodiment, photovoltaic system 1000 can be applied to photovoltaic power plants, such as ground power plants, rooftop power plants, surface power plants, etc., as well as to the equipment or devices that utilize solar energy for power generation, like users' solar power sources, solar street lights, solar cars, solar buildings, etc. It can be understood that, of course, the application scenarios of photovoltaic system 1000 are not limited to these, that is, photovoltaic system 1000 can be further applied in all fields that realize power generation based on solar energy. Taking photovoltaic power generation system network as an example, photovoltaic system 1000 can include photovoltaic system, combiner box and inverter. photovoltaic system can be an array combination of a plurality of back-contact cell assembly 200. A plurality of photovoltaic systems, for example, can be formed by a plurality of back-contact cell assemblies 200. photovoltaic system is connected to combiner box which can converge the current generated by photovoltaic system, and the converged current, after flowing through the inverter and being converted into AC power required by the municipal power grid, is then connected to the municipal power grid to provide solar power.

In some embodiments, the first edge primary gate 131 may be disposed at the first edge 101 of the back-contact solar cell 100. Specifically, "the first edge primary gate 131 is disposed at the first edge 101" can be understood as being disposed on the edge line of the first edge 101 of the back-contact solar cell 100, or without additional secondary gates between the first edge primary gate 131 and the edge line of the back-contact solar cell 100.

### Embodiment 2

Referring to FIG. 6, in some embodiments, no solder joints are provided on the first edge primary gate 131 for welding, which can save solder joint related materials and reduce costs while also avoiding edge cracks during the welding process.

In some embodiments, the first edge primary gate 131 is not used for welding so that cracks caused by welding at the edges are avoided.

In such a case, it can be understood that the first edge primary gate 131 is not provided with solder joints and/or not used for welding, or solder joints are provided on the first edge primary gate 131 but not used for welding, preferably no solder joints are provided on the first edge primary gate 131 and used for welding.

### Embodiment 3

In some embodiments, a plurality of first confluence gate lines 112 and first discontinuous zones 140 may be provided, and each first discontinuous zone 140 corresponds to at least one first confluence gate line 112.

The first edge primary gate 131 and the first primary gate 13 adjacent to the first edge primary gate 131 can be connected through a plurality of first confluence gate lines 112 to improve the confluence efficiency.

Specifically, in such embodiments, preferably a first discontinuous zone 140 corresponds to a first confluence gate line 112, in order to avoid poor welding (such as false soldering) with the second primary gate 14 of the first edge primary gate 131 due to the excessive width of the first discontinuous zone 140, and to ensure the reliability of welding.

It should be noted that FIG. 6 only presents a first confluence gate line 112, and some of the secondary and primary gates of the electrode structure, which merely serve as examples. It can be understood that in some embodiments, a plurality of first secondary gates 11 and second secondary gates 12, as well as first confluence gate lines 112 can also be provided below the first confluence gate line 112 in FIG. 6. The specific number can be determined based on the size of the back-contact solar cell 100, which are subject to no restrictions here.

### Embodiment 4

In some embodiments, a plurality of first confluence gate lines 112 are symmetrically arranged along the centerline of the back-contact solar cell 100 in the arrangement direction of the first secondary gate and the second secondary gate 11 & 12.

A plurality of first confluence gate lines 112 which are symmetrically disposed can ensure that each first confluence gate line 112 has basically the same convergence path when collecting current on the first edge primary gate 131, avoiding the current convergence with a larger overall losses due to the significant differences in the convergence paths that may result in varied losses on different paths.

Specifically, in such an embodiment, a plurality of first confluence gate lines 112 are symmetrically disposed along the centerline of back-contact solar cell 100 in the arrangement direction of the first secondary gate and the second secondary gate 11 and 12, that is, the first confluence gate lines 112 are symmetrically disposed in the two vertically symmetric areas of the back-contact solar cell 100, and each first confluence gate lines 112 maintains the same distance with the connection point of the first edge primary gate 131. During confluence, the confluence from the first edge primary gate 131 to each first confluence gate line 112 basically has the same confluence path and loss, ensuring the confluence performance and improving the confluence efficiency.

It can be understood that, of course, in some embodiments, a single first confluence gate line 112 can also be disposed at the center of the back-contact solar cell 100, that is, the connection point between a single first confluence gate line 112 and the first edge primary gate 131 is located at the midpoint of the first edge primary gate 131.

In this way, the use of a single first confluence gate line 112 at the center position ensures that the current collected by the first confluence gate line 111 has basically the same convergence path, avoiding significant differences in convergence paths that may lead to increased overall losses and ensuring the convergence effect.

Specifically, in such an embodiment, a single first confluence gate line 112 can be connected at the midpoint of the first edge primary gate 131 to divide the back-contact solar cell 100 into two vertically symmetrical regions, so that the current collected by the first collection gate line 111 in the upper and lower regions has basically the same confluence path on the first edge primary gate 131, ensuring the confluence effect.

### Embodiment 5

In some embodiments, the width of the first confluence gate lines 112 can be 80um-1.5mm.

In this way, the first confluence gate lines 112 having a rational width within the range of 80um-1.5mm can ensure its convergence effect, and prevent the first confluence gate lines 112 from overheating or even melting since the first confluence gate lines 112 with too small width fail to withstand the current from the first edge primary gates 131, and also avoid the waste of paste as a result of the first confluence gate lines 112 with too large width.

Specifically, in such embodiments, the width of the first confluence gate line 112 can be any one of the values from 80um, 100um, 200um, 300um, 400um, 500um, 600um, 700um, 800um, 900um, 1mm, 1.1mm, 1.2mm, 1.3mm, 1.4mm, 1.5mm, or 80um-1.5mm, which are subject to no restrictions here.

In further, in some embodiments, the width of the first confluence gate line 112 may be preferably greater than 1.5 times that of the first collection gate line 111.

The first confluence gate line 112 with a width greater than 1.5 times that of the first collection gate line 111 can ensure a better confluence effect and reliability.

Specifically, it can be understood that in the embodiment of the present application, the current that flows through the first confluence gate line 112 is the converged one flowing through the first edge primary gate 131. The width of the first confluence gate line 112 therefore can be preferably 1.5 times larger than that of the first collection gate line 111, ensuring the first confluence gate line 112 with a larger width and better convergence reliability.

In some embodiments, the distance between the two second secondary gates 12 adjacent to the first confluence gate line 112 is greater than the distance between the other adjacent second secondary gates 12.

In this way, a larger spacing between the two second secondary gates 12 adjacent to the first confluence gate line 112 provides the first confluence gate line 112 with a larger width, ensuring the convergence effect and reliability.

### Embodiment 6

Referring to FIG. 6, in some embodiments, a plurality of first solder joints 142 are spaced on the second primary gate 14 adjacent to the first edge primary gate 131;

The first discontinuous zone 140 is located between two adjacent first solder joints 142.

The arrangement of the first discontinuous zone 140 at two adjacent first solder joints 142 can, while realizing the convergence, ensure the integrity of the first solder joint 142 and support the welding with the second primary gate 14 adjacent to the first edge primary gate 131.

Specifically, in such an embodiment, a plurality of first solder joints 142 can be evenly spaced on the second primary gate 14 adjacent to the first edge primary gate 131 (FIG. 6 only exemplify two first solder joints 142). Preferably, a single first discontinuous zone 140 is provided between the adjacent first solder joints 142 and a single first confluence gate line 112 corresponding to the first discontinuous zone 140 is provided, so that at least a first confluence gate line 112 is provided between each two first solder joints 142 to reduce the number and width of the first discontinuous zone 140 between adjacent first solder joints 142, and avoid affecting the welding with the second primary gate 14 adjacent to the first edge primary gate 131.

In such an embodiment, the distance between two adjacent first solder joints 142 on the second primary gate 14 adjacent to the first edge primary gate 131 can be greater than 5mm, preferably greater than 9mm. In some embodiments, in order to reduce the use of paste at the first solder joint 142 of the same size, the distance between two adjacent first solder joints 142 can be greater than 11mm but less than or equal to 45mm.

In further, in such embodiments, the spacing between two adjacent first solder joints 142 may be preferably greater than 11mm but less than or equal to 30mm. The first solder joints 142 having a spacing within this optimal range can ensure the number of first solder joints 142 to provide welding reliability without poor welding, and also avoid an increasing costs due to the excessive number of first solder joints 142.

Of course, referring to FIG. 7, in some embodiments, the first discontinuous zone 140 can also be formed on the first solder joint 142, that is, a first discontinuous zone 140 is provided on the first solder joint 142.

A first discontinuous zone 140 is formed on each first solder joint 142, and both the first discontinuous zones 140 and the first confluence gate lines 112 are are uniformly arranged to ensure the convergence effect.

Specifically, as shown in FIG. 7, in such a case, the first solder joint 142 can be divided by the first discontinuous zone 140 into two parts that are arranged opposite at intervals. The first discontinuous zone 140 can preferably be disposed at the center of the first solder joint 142, and the first confluence gate line 112 running through the center of first solder joint 142 connects the first edge primary gate 131 and the first primary gate 13 adjacent to the first edge primary gate 131, so as to converge the first edge primary gates 131.

In such cases, in order to avoid the formation of a first discontinuous zone 140 in the first solder joint 142 from affecting the subsequent welding, the first solder joint 142 can be set to be longer or wider to ensure the reliability of subsequent welding.

### Embodiment 7

In further, referring to FIG. 6, in some embodiments, the first discontinuous zone 140 may be located between two adjacent first solder joints 142. The distance between the first confluence gate line 112 running through the first discontinuous zone 140 and the centerline between two adjacent first solder joints 142 is less than or equal to 20mm, that is, the distance between the first confluence gate line 112 and the midpoint between two adjacent first solder joints 142 is less than or equal to 20mm.

A suitable distance can be maintained between the first confluence gate line 112 and the first solder joint 142 to avoid the problem of false soldering during welding due to the presence of the first confluence gate line 112, and the distance between the first confluence gate line 112 and the center between two first solder joints 142 can also be maintained within a reasonable range, so that the convergence effect will not be affected due to the significantly different convergence path of the current from the first collection gate lines 111 on both sides of the first confluence gate line 112.

It can be understood that, in some embodiments, during printing process, the height of the first confluence gate line 112 is the same as or even slightly higher than that of the first solder joint 142. The distance between the first confluence gate line 112 and the first solder joint 142 cannot be too small, otherwise the certain height difference between them may lead to false soldering during welding. Therefore, a distance less than or equal to 20mm between the first confluence gate line 112 and the centerline of two adjacent first solder joints 142 can effectively avoid the false soldering and increased defect rate due to the small distance between them.

If, meanwhile, a large distance deviation between the first confluence gate line 112 and the centerline between two first solder joints 142 will lead to a significant difference in the convergence path and corresponding losses when convergence is made from the upper and lower sides of the first confluence gate 112, which affects the convergence effect. Therefore, a distance of less than or equal to 20mm between the first confluence gate 112 and the centerline between two adjacent first solder joints 142 can effectively ensure the convergence effect of the first confluence gates 112.

In further, in such an embodiment, the distance between the first confluence gate line 112 running through the first discontinuous zone 140 and the centerline between the two adjacent first solder joints 142 may be less than or equal to 10mm. A distance within this preferred range between the first confluence gate line 112 and the two first solder joints 142 can effectively ensure the convergence effect.

In such an embodiment, the first discontinuous zone 140 is located between two adjacent first solder joints 142. The distance between the first confluence gate line 112 running through the first discontinuous zone 140 and the centerline between two adjacent first solder joints 142 can be preferably less than or equal to 5mm, preferably less than or equal to 3mm, and most preferably 1mm, so that the first confluence gate line 112 can overlap with the centerline between the two first solder joints 142 as much as possible to ensure a basically same convergence path from the top to bottom direction and a better convergence effect.

Specifically, in such an embodiment, ideally, the first confluence gate line 112 is disposed at the centerline of two adjacent first solder joints 142, that is, the first confluence gate line 112 coincides the centerline between two adjacent first solder joints 142, with a distance of 0, providing exactly the same paths in all directions and the best convergence effect. In some embodiments, of course, the distance between the first confluence gate line 112 running through the first discontinuous zone 140 and the centerline between two adjacent first solder joints 142 can also be 1mm, 0.8mm, 0.6mm, 0.4mm, 0.2mm, and 0.1mm, most preferably 0, which are subject to no limitations here.

### Embodiment 8

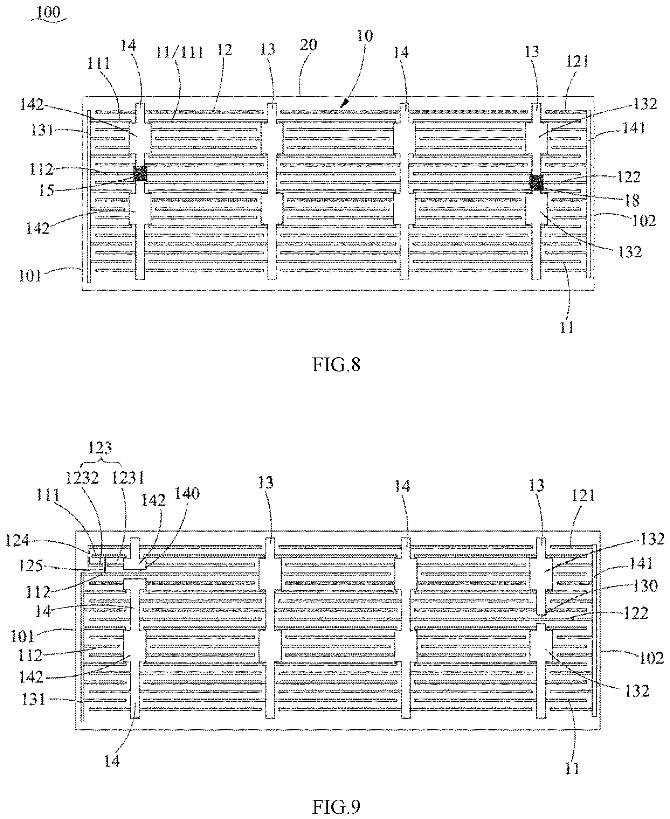

Referring to FIG. 8, in some embodiments, the first discontinuous zone 140 can be covered with a first insulation layer 15.

Covering the first discontinuous zone 140 with a first insulation layer 15 can avoid electric leakage caused by the contact between the welding rod and the first confluence gate line 112 when welding the first solder j oint 142.

Specifically, for the purpose of insulation, the size of the first insulation layer 15 can be equal to or slightly larger than that of the first discontinuous zone 140, that is, only the area on the second primary gate 14 corresponding to the first discontinuous zone 140 is covered with the first insulation layer 15, and no first insulation layer 15 is disposed in other areas. The first insulation layer 15 can be an insulating adhesive.

### Embodiment 9

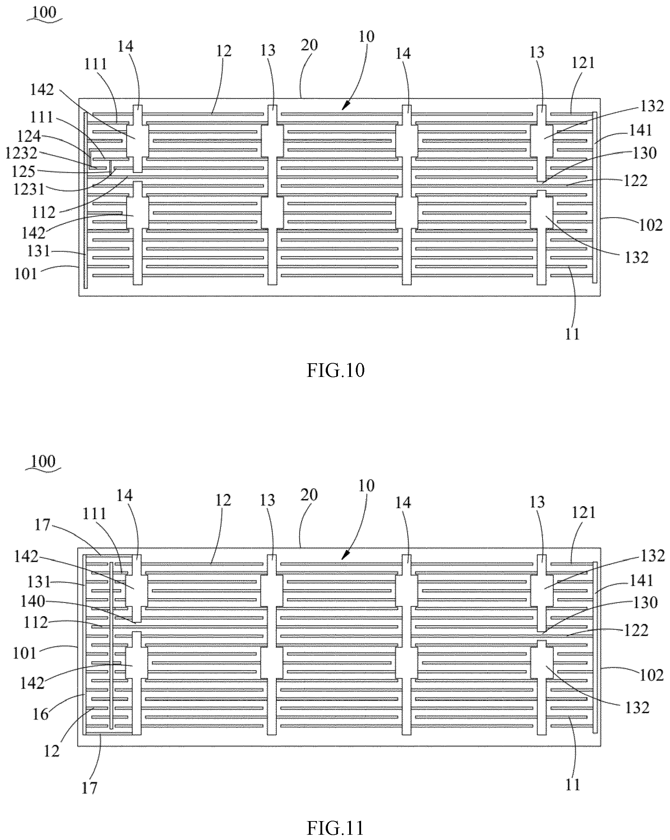

Referring to FIG. 9 and 10, in some embodiments, the second secondary gate 12 may include a first discontinuous gate line 123 adjacent to the first confluence gate line 112 and a first curved gate line 124 adjacent to the first discontinuous gate line 123. The first discontinuous gate line 123 includes a first connection section 1231 and a second connection section 1232 which are disposed at intervals, and a first gap is formed between the first connection section 1231 and the second connection section 1232;

The first connection section 1231 is connected to the second primary gate 14 adjacent to the first edge primary gate 131, and the second connection section 1232 connecting to the first curved gate line 124 surrounds the end of the first collection gate line 111 between the first discontinuous gate line 123 and the first curved gate line 124, and the first collection gate line 111 between the first discontinuous gate line 123 and the first curved gate line 124 is not connected to the first edge primary gate 131 but to the first confluence gate line 112 through the first penetrating gate line 125 that passes the first gap.

In this way, the connection between the first curved gate line 124 and the first connection section 1231 can surround the first collection gate line 111 between the first discontinuous gate line 123 and the first curved gate line 124, while the connection between the first confluence gate line 112 and the surrounded first collection gate line 111 through the first penetrating gate line that passes the first gap can converge the first collection gate lines 111 that are not connected to the first edge primary gate 131.

Specifically, in the embodiment shown in FIG. 9, the first discontinuous gate line 123 is adjacent to the first confluence gate line 112, the first curved gate line 124 can be disposed in the upper left corner of the back-contact solar cell 100. The first confluence gate line 112 can penetrate the first solder joint 142, that is, the first discontinuous zone 140 is located on the first solder joint 142, and the first curved gate line 124 which end bends towards the first confluence gate line 112 connects to the second connection section 1232 of the first discontinuous gate line 123, and both the first curved gate line 124 and the second connection section 1232 wrap the first collection gate line 111 adjacent to the first curved gate line 124. The first collection gate line 111 wrapped by the first curved gate line 124 is not connected to the first edge primary gate 131, but to the first confluence gate line 112 for convergence through the first penetrating gate line 125 that passes through the first gap. In such an embodiment, it can be understood that the second polar region can match the corresponding first curved gate line 124 in shape.

In addition, in the embodiment shown in FIG. 10, the first curved gate line 124 can also be located in the middle of the back-contact solar cell 100, and the first discontinuous zone 140 is located between two adjacent first solder joints 142, which are subject to no limitations here. Of course, in other embodiments, the first curved gate line 124 can also be disposed in any other position of the back-contact solar cell 100, and single or a plurality of first curved gate lines 124 and first discontinuous gate lines 123 can be provided, which are subject to no limitations here.

### Embodiment 10

Referring to FIG. 11, in some embodiments, the electrode structure 10 may also include a first bus electrode 16 adjacent to the first edge primary gate 131, without solder joints on the first bus electrode 16. The first bus electrode 16, which is closer to the first edge 101 than to the first edge primary gate 131, is connected to the second secondary gate 12 located between the first edge primary gate 131 and the first bus electrode 16, that is, the first bus electrode 16 has the same polarity as the second secondary gate 12 and the second primary gate 14.

The electrode structure 10 also includes a first connection gate line 17 located at the ends of the first primary gate 13 and of the second primary gate 14. The first connection gate line 17 which is not disconnected at the first edge primary gate 131 is connected to the first bus electrode 16 and to the second primary gate 14 adjacent to the first edge primary gate 131.

In this way, the use of a first bus electrode 16, which is closer to the first edge 101 than to the first edge primary gate 131, can converge the current collected by the second secondary gate 12 located in the area near the first edge 101 to the second primary gate 14 adjacent to the first edge primary gate 131 through the first connection gate line 17, without welding on the first bus electrode 16, which can avoid cracking due to stress concentration during welding at the edges, and it is not required to set the secondary gates in the edge area with the same polarity as in FIG. 3 of the prior art, which may lead to poor photoelectric conversion performance.

Specifically, as shown in FIG. 11, the first bus electrode 16 has the same polarity as the second primary gate 14, and a second secondary gate 12 (i.e. the one located near the first edge 101) that is disconnected at the first edge primary gate 131 is provided between the second bus electrode 19 and the first edge primary gate 131. The second bus electrode 19 can converge the current collected by the second secondary gate 12 located in the edge area to the adjacent second primary gate 14 through the first connection gate line 17.

In further, as shown in FIG. 11, in some embodiments, two first connection gate lines 17 are located at both ends of the first primary gate 13 and the second primary gate 14, respectively.

The two first connection gate lines 17 ensures the uniform convergence of the second secondary gates 12 in the edge area near the first edge 101, avoiding reduced efficiency due to a long convergence path.

Specifically, as shown in FIG. 11, two first connection gate lines 17 can be connected to both ends of the first bus electrode 16 and of the adjacent second primary gate 14, that is, the first connection gate line 17, the first bus electrode 16, and the adjacent second primary gate 14 jointly enclose the first edge primary gate 131 and the secondary gate between the first edge primary gate 131 and the first bus electrode 16.

As shown in FIG. 11, in some embodiments, the spacing between the first edge primary gate 131 and the second primary gate 14 adjacent to the first edge primary gate 131 may be smaller than that between the other adjacent first primary gates 13 and the second primary gates 14, that is, in such a case, the first primary gates 13 and the second primary gates 14 can be arranged at uneven intervals, and the distance between the first edge primary gate 131 and the adjacent second primary gate 14 can be smaller, with or without secondary gates between them, which are subject to no restrictions here.

In some embodiments, the first bus electrode 16 is located at the first edge 101. Specifically, "the first bus electrode 16 is located at the first edge 101" can be understood as being disposed on the edge line of the back-contact solar cell 100 or without additional secondary gates between the first bus electrode 16 and the edge line of the back-contact solar cell 100.

### Embodiment 11

In some embodiments, the width of the first connection gate lines 17 can be 80um-1.5mm.

In this way, the first connection gate lines 17 having a rational width within the range of 80um-1.5mm can ensure its convergence effect, and prevent the first connection gate lines 17 from overheating or even melting since the first connection gate lines 17 with too small width fail to withstand the current from the first bus electrode 16, and also avoid the waste of paste as a result of the first connection gate lines 17 with too large width.

Specifically, in such embodiments, the width of the first connection gate line 17 can be any one of the values from 80um, 100um, 200um, 300um, 400um, 500um, 600um, 700um, 800um, 900um, 1mm, 1.1mm, 1.2mm, 1.3mm, 1.4mm, 1.5mm, or 80um-1.5mm, which are subject to no restrictions here.

In further, in some embodiments, the width of the first connection gate line 17 may be preferably greater than 1.5 times that of the second secondary gate 12.

The first connection gate line 17 with a width greater than 1.5 times that of the second secondary gate 12 can ensure a better confluence effect and reliability.

Specifically, it can be understood that in the embodiment of the present application, the current that flows through the first connection gate line 17 is the converged one flowing through the first confluence gate line 112. The width of the first connection gate line 17 therefore can be preferably 1.5 times larger than that of the second gate line 11, ensuring the first connection gate line 17 with a larger width and better convergence reliability.

### Embodiment 12

Referring to FIG. 6 again, in some embodiments, the second primary gate 14 may include a second edge primary gate 141 (i.e. the rightmost second primary gate 14 in FIG. 6) located on one side near the second edge 102 (i.e. the right edge in FIG. 6) of the back-contact solar cell 100, with the second edge 102 and the first edge 101 arranged opposite to each other;

A plurality of second secondary gates 12 may include a second collection gate line 121 and a second confluence gate line 122. The second collection gate line 121, which is disconnected at the first primary gate 13, forms a second discontinuous zone 130 with the first primary gate 13 adjacent to the second edge primary gate 141 (i.e. the #1 first primary gate 13 from right to left in FIG. 6). One end of the second confluence gate line 122 is connected to the second edge primary gate 141, and the other end passes through a second discontinuous zone 130 and is connected to the second primary gate 14 adjacent to the second edge primary gate 141 (i.e. the #2 second primary gate 14 from right to left in FIG. 6).
The second collection gate line 121 of the second secondary gate 12 is disconnected at the first primary gate 13, and the second edge primary gate 141 of the second primary gate 14 is connected to the second collection gate line 121 in the second secondary gate 12 to collect the current in the first polar region near the second edge 101 through the second collection gate line 121, and the second confluence gate line 122 passes through the second discontinuous zone 130 on the first primary gate adjacent to the second edge primary gate 141 to connect the second edge primary gate 141 as well as the second primary gate 14 adjacent to the second edge primary gate 141. The current collected by the second edge primary gate 141 can be transmitted for convergence and collection purpose through the second confluence gate line 122 to the second primary gate 14 adjacent to the second edge primary gate 141. In this way, the second edge primary gate 141 is located on the side near the first edge 101 of the back-contact solar cell 100. The first edge primary gate 131 can directly connect and converge with the adjacent first primary gate 13 through the first confluence gate line 112. Compared to the electrode pattern design in FIG. 2 of the prior art, the convergence of adjacent edge area of the second edge 102 without welding on the first edge primary gate 131 can avoid stress concentration during welding and improve the yield and reliability of assembly. Moreover, compared to the third type of electrode pattern design of the prior art, the photogenerated electron holes near the first edge can, without spanning a long distance, reach the opposite region to collect the current and fully ensures a high photoelectric conversion.

In the embodiment shown, "second edge 102" refers to the right edge in FIG. 6, and "the second edge primary gate 141 is located on the side near the second edge 102" means that the second edge primary gate 141 is the rightmost second primary gate 14 in FIG. 6, that is, the second primary gate 14 near the second edge 102 can be a certain distance from the second edge 102 of the back-contact solar cell 100, or can also be the second edge 102 that is directly disposed on the back-contact solar cell 100 (i.e. the right edge in FIG. 6), which are subject to no restrictions here.

In the embodiment of the present application, "the second edge primary gate 141 forms a second discontinuous zone 130" means that the second edge primary gate 141, a discontinuous structure, is separated at the second discontinuous zone 140, that is, the second edge primary gate 141 is separated into at least two parts by the second discontinuous zone 140.

It can also be understood that in the process of forming the second edge primary gate 141, a screen plate can be used to cover the position corresponding to the second discontinuous zone 140, and the second edge primary gate 141 with a second discontinuous zone 140 can be formed through printing or electroplating and evaporation.

In further, as shown in FIG. 6, it can be understood that in the embodiment of the present application, the first secondary gate 11 and the second secondary gate 12 are alternatively disposed between the first edge primary gate 131 and the second primary gate 14 adjacent to the second edge primary gate 141. The second collection gate line 121 in the second secondary gate 12 between the two is connected to the second edge primary gate 141, and the first secondary gate 11 is connected to the first primary gate 13 adjacent to the second edge primary gate 141, and the second confluence gate line 122 passing through the second discontinuous zone 130 is connected to the first primary gate 13 adjacent to the second edge primary gate 141.

The second edge primary gate 141 can converge the current collected by the second collection gate line 121 between the second edge primary gate 141 and the first primary gate 13 adjacent to the second edge primary gate 141, and the current then flows through the second collection gate line 122 to the second primary gate 14 adjacent to the second edge primary gate 141, so that the current generated in the second polar region of the edge region near the second edge 10 is collected and converged, without welding on the second edge primary gate 141, which avoids the occurrence of cracks on the edge of the back-contact solar cell 100 during the welding.

Similarly, like the first confluence line 112, in some embodiments, since the second confluence gate line 122 is connected to the second edge primary gate 141 and the second primary gate 14 adjacent to the second edge primary gate 141 to converge the second edge primary gate 141 and the adjacent first primary gate 13, the second confluence gate lines 122 may preferably be copper gate lines with smaller current loss.

In some embodiments, the second edge primary gate 141 is located at the second edge 102 of the back-contact solar cell 100. Specifically, "he second edge primary gate 141 is located at the second edge 102 of the back-contact solar cell 100" can be understood as being disposed on the edge line of the back-contact solar cell 100 or without additional secondary gates between the second edge primary gate 141 and the edge line of the back-contact solar cell 100.

### Embodiment 13

In further, like the first edge primary gate 131, in some embodiments, no solder joints are provided on the second edge primary gate 141 for welding, which can save solder joint related materials and reduce costs while also avoiding edge cracks during the welding process.

In some embodiments, the second edge primary gate 141 is not used for welding so that cracks caused by welding at the edges are avoided.

In such a case, it can be understood that the second edge primary gate 141 is not provided with solder joints and/or not used for welding, or solder joints are provided on the second edge primary gate 141 but not used for welding, preferably no solder joints are provided on the second edge primary gate 141 and used for welding.

### Embodiment 14

In some embodiments, like the first confluence gate lines 112, a plurality of second confluence gate lines 122 and a plurality of second discontinuous zones 130 may be provided, and each second discontinuous zone 130 corresponds to at least one second confluence gate line 122.

The second edge primary gate 141 and the second primary gate 14 adjacent to the second edge primary gate 141 can be connected through a plurality of second confluence gate lines 122 to improve the confluence efficiency.

Specifically, in such embodiments, preferably a second discontinuous zone 130 corresponds to a second confluence gate line 122, in order to avoid poor welding (such as false soldering) with the second primary gate 14 of the second edge primary gate 141 due to the excessive width of the second discontinuous zone 130, and to ensure the reliability of welding.

It should be noted that FIG. 6 only presents a second confluence gate line 122, and some of the secondary and primary gates of the electrode structure, which merely serve as examples. It can be understood that in some embodiments, a plurality of first secondary gates 11 and second secondary gates 12, as well as second confluence gate lines 122 can also be provided below the second confluence gate line 122 in FIG. 6. The specific number can be determined based on the size of the back-contact solar cell 100, which are subject to no restrictions here.

### Embodiment 15

In some embodiments, a plurality of second confluence gate lines 122 are symmetrically arranged along the centerline of the back-contact solar cell 100 in the arrangement direction of the first secondary gate 11 and the second secondary gate 12.

A plurality of second confluence gate lines 122 which are symmetrically disposed can ensure that each second confluence gate line 122 has basically the same convergence path when collecting current on the second edge primary gate 141, avoiding the current convergence with a larger overall losses due to the significant differences in the convergence paths that may result in varied losses on different paths.

Specifically, in such an embodiment, a plurality of second confluence gate lines 122 are symmetrically disposed along the centerline of back-contact solar cell 100 in the arrangement direction of the first secondary gate and the second secondary gate 11 and 12, that is, the second confluence gate lines 122 are symmetrically disposed in the two vertically symmetric areas of the back-contact solar cell 100, and each second confluence gate lines 122 maintains the same distance with the connection point of the second edge primary gate 141. During confluence, the confluence from the second edge primary gate 141 to each second confluence gate line 122 basically has the same confluence path and loss, ensuring the confluence performance and improving the confluence efficiency.

It can be understood that, of course, in some embodiments, a single second confluence gate line 122 can also be disposed at the center of the back-contact solar cell 100, that is, the connection point between a single second confluence gate line 122 and the second edge primary gate 141 is located at the midpoint of the second edge primary gate 141.

In this way, the use of a single second confluence gate line 122 at the center position ensures that the current collected by the second confluence gate line 121 has basically the same convergence path, avoiding significant differences in convergence paths that may lead to increased overall losses and ensuring the convergence effect.

Specifically, in such an embodiment, a single second confluence gate line 122 can be connected at the midpoint of the second edge primary gate 141 to divide the back-contact solar cell 100 into two vertically symmetrical regions, so that the current collected by the second collection gate line 121 in the upper and lower regions has basically the same confluence path on the second edge primary gate 141, ensuring the confluence effect.

### Embodiment 16

In some embodiments, the width of the second confluence gate lines 122 can be 80um-1.5mm.

In this way, the second confluence gate lines 122 having a rational width within the range of 80um-1.5mm can ensure its convergence effect, and prevent the second confluence gate lines 122 from overheating or even melting since the second confluence gate lines 122 with too small width fail to withstand the current from the second edge primary gate 141, and also avoid the waste of paste as a result the second confluence gate lines 122 with too large width.

Specifically, in such embodiments, the width of the second confluence gate line 122 can be any one of the values from 80um, 100um, 200um, 300um, 400um, 500um, 600um, 700um, 800um, 900um, 1mm, 1.1mm, 1.2mm, 1.3mm, 1.4mm, 1.5mm, or 80um-1.5mm, which are subject to no restrictions here.

In further, in some embodiments, the width of the second confluence gate line 122 may be preferably greater than 1.5 times that of the second collection gate line 121.

The second confluence gate line 122 with a width greater than 1.5 times that of the second collection gate line 121 can ensure a better confluence effect and reliability.

Specifically, it can be understood that in the embodiment of the present application, the current that flows through the second confluence gate line 122 is the converged one flowing through the second edge primary gate line 141. The width of the second confluence gate line 122 therefore can be preferably 1.5 times larger than that of the first connection gate line 111, ensuring the second confluence gate line 122 with a larger width and better convergence reliability.

In some embodiments, the distance between the two first secondary gates 11 adjacent to the second confluence gate line 122 is greater than the distance between the other adjacent first secondary gates 11.

In this way, a larger spacing between the two first secondary gates 11 adjacent to the second confluence gate line 122 provides the second confluence gate line 122 with a larger width, ensuring the convergence effect and reliability.

### Embodiment 17

Referring to FIG. 6, in some embodiments, a plurality of second solder joints 132 are spaced on the first primary gate 13 adjacent to the second edge primary gate 141;

The second discontinuous zone 130 is located between two adjacent second solder joints 132.

The arrangement of the second discontinuous zone 130 at two adjacent second solder joints 132 can, while realizing the convergence, ensure the integrity of the second solder joint 132 and support the welding with the first primary gate 13 adjacent to the second edge primary gate 141.

Specifically, in such an embodiment, a plurality of second solder joints 132 can be evenly spaced on the first primary gate 13 adjacent to the second edge primary gate 141 (FIG. 6 only exemplify two first solder joints 142). Preferably a single second discontinuous zone 130 is provided between the adjacent second solder joints 132 and a single second confluence gate line 122 corresponding to the second discontinuous zone 130 is provided, so that at least a second confluence gate line 122 is provided between each two second solder joints 132 to reduce the number and the width of the second discontinuous zone 130 between adjacent second solder joints 132, and to avoid affecting the welding with the first primary gate 13 adjacent to the second edge primary gate 141.

In such an embodiment, the distance between two adjacent second solder joints 132 on the first primary gate 13 adjacent to the second edge primary gate 141 can be greater than 5mm, preferably greater than 9mm. In some embodiments, in order to reduce the use of paste at the second solder joint 132 of the same size, the distance between two adjacent second solder joints 132 can be greater than 11mm but less than or equal to 45mm.

In further, in such embodiments, the spacing between two adjacent second solder joints 132 may be preferably greater than 11mm but less than or equal to 30mm. The second solder joints 132 having a spacing within this optimal range can ensure the number of second solder joints 132 to provide welding reliability without poor welding, and also avoid an increasing costs due to the excessive number of second solder joints 132.

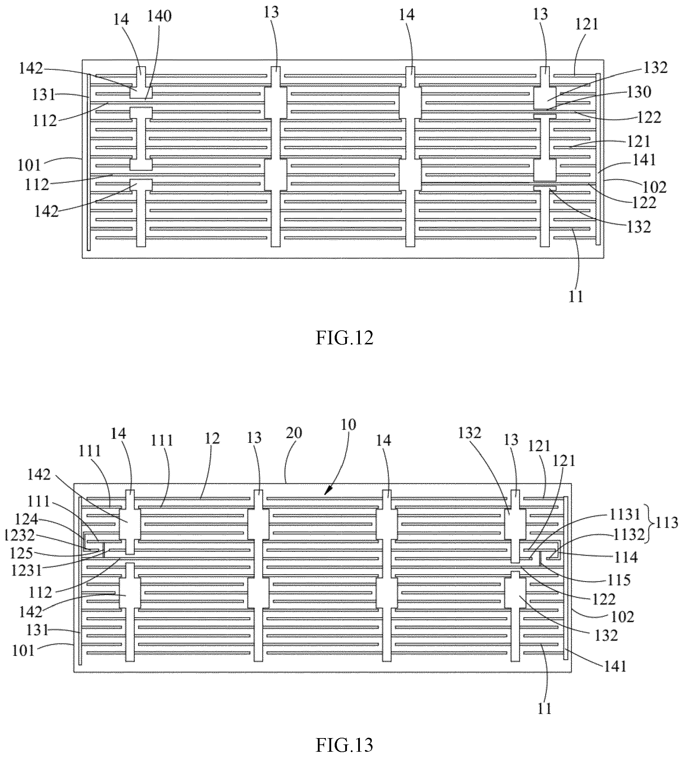

Of course, referring to FIG. 12, in some embodiments, the second discontinuous zone 130 can also be formed on the second solder joint 132, that is, a second discontinuous zone 130 is provided on the second solder joint 132.

A second discontinuous zone 130 is formed on each second solder joint 132, and both the second discontinuous zones 130 and the second confluence gate lines 122 are are uniformly arranged to ensure the convergence effect.

Specifically, as shown in FIG. 12, in such a case, the second solder joint 132 can be divided by the second discontinuous zone 130 into two parts that are arranged opposite at intervals. The second discontinuous zone 130 can preferably be disposed at the center of the second solder joint 132, and the second confluence gate line 122 running through the center of second solder joint 132 connects the second edge primary gate 141 and the second primary gate 14 adjacent to the second edge primary gate 141, so as to converge the second edge primary gates 141.

In such cases, in order to avoid the formation of a second discontinuous zone 130 in the second solder joint 132 from affecting the subsequent welding, the second solder joint 132 can be set to be longer or wider to ensure the reliability of subsequent welding.

### Embodiment 18

In further, referring to FIG. 6, in some embodiments, the second discontinuous zone 130 may be located between two adjacent second solder joints 132. The distance between the second confluence gate line 122 running through the second discontinuous zone 130 and the centerline between two adjacent second solder joints 132 is less than or equal to 20mm, that is, the distance between the second confluence gate line 122 and the midpoint between two adjacent second solder joints 132 is less than or equal to 20mm.

A suitable distance can be maintained between the second confluence gate line 122 and the second solder joint 132 to avoid the problem of false soldering during welding due to the presence of the second confluence gate line 122, and the distance between the second confluence gate line 122 and the center between two second solder joints 132 can also be maintained within a reasonable range, so that the convergence effect will not be affected due to the significantly different convergence path of the current from the first collection gate lines 111 on both sides of the second confluence gate line 122.

It can be understood that, in some embodiments, during printing process, the height of the second confluence gate line 122 is the same as or even slightly higher than that of the second solder joint 132. The distance between the second confluence gate line 122 and the second solder joint 132 cannot be too small, otherwise the certain height difference between them may lead to false soldering during welding. Therefore, a distance less than or equal to 20mm between the second confluence gate line 122 and the centerline of two adjacent second solder joint 132 can effectively avoid the false soldering and increased defect rate due to the small distance between them.

If, meanwhile, a large distance deviation between the second confluence gate line 122 and the centerline between two second solder joints 132 will lead to a significant difference in the convergence path and corresponding losses when convergence is made from the upper and lower sides of the second confluence gate 122, which affects the convergence effect. Therefore, a distance of less than or equal to 20mm between the second confluence gate 122 and the centerline between two adjacent second solder joints 132 can effectively ensure the convergence effect of the second confluence gates 122.

In further, in such an embodiment, the distance between the second confluence gate line 122 running through the second discontinuous zone 130 and the centerline between the two adjacent second solder joints 132 may be less than or equal to 10mm. A distance within this preferred range between the second confluence gate line 122 and the two second solder joints 132 can effectively ensure the convergence effect.

In such an embodiment, the second discontinuous zone 130 is located between two adjacent second solder joints 132. The distance between the second confluence gate line 122 running through the second discontinuous zone 130 and the centerline between two adjacent second solder joints 132 can be preferably less than or equal to 5mm, preferably less than or equal to 3mm, and most preferably 1mm, so that the second confluence gate line 122 can overlap with the centerline between the two second solder joints 132 as much as possible to ensure a basically same convergence path from the top to bottom direction and a better convergence effect.

Specifically, in such an embodiment, ideally, the second confluence gate line 122 is disposed at the centerline of two adjacent second solder joints 132, that is, the second confluence gate line 122 coincides the centerline between two adjacent second solder joints 132, with a distance of 0, providing exactly the same paths in all directions and the best convergence effect. In some embodiments, of course, the distance between the second confluence gate line 122 running through the second discontinuous zone 130 and the centerline between two adjacent first solder joints 142 can also be 1mm, 0.8mm, 0.6mm, 0.4mm, 0.2mm, and 0.1mm, most preferably 0, which are subject to no limitations here.

### Embodiment 19

Referring to FIG. 8, in some embodiments, the second discontinuous zone 130 can be covered with a second insulation layer 18.

Covering the second discontinuous zone 130 with a second insulation layer 18 can avoid electric leakage caused by the contact between the welding rod and the second confluence gate line 122 when welding the second solder joint 132.

Specifically, for the purpose of insulation, the size of the second insulation layer 18 can be equal to or slightly larger than that of the second discontinuous zone 130, that is, only the area on the first primary gate 13 corresponding to the second discontinuous zone 130 is covered with the second insulation layer 18, and no second insulation layer 18 is disposed in other areas. The second insulation layer 18 can be an insulating adhesive.

### Embodiment 20

Referring to FIG. 13, in some embodiments, the second secondary gate 12 may include a second discontinuous gate line 122 adjacent to the second confluence gate line 113 and a second curved gate line 114 adjacent to the second discontinuous gate line 113. The second discontinuous gate line 113 includes a third connection section 1131 and a fourth connection section 1132 which are disposed at intervals, and a second gap is formed between the third connection section 1131 and the fourth connection section 1132;

The third connection section 1131 is connected to the first primary gate 13 adjacent to the second edge primary gate 141, and the fourth connection section 1232 connecting to the second curved gate line 114 surrounds the end of the second collection gate line 121 between the second discontinuous gate line 113 and the second curved gate line 114, and the second collection gate line 121 between the second discontinuous gate line 113 and the second curved gate line 114 is not connected to the second edge primary gate 141, but to the second confluence gate line 122 through the second penetrating gate line 115 that passes the second gap.

In this way, the connection between the second curved gate line 114 and the third connection section 1131 can surround the second collection gate line 121 between the second discontinuous gate line 113 and the second curved gate line 114, while the connection between the second confluence gate line 122 and the surrounded second collection gate line 121 through the second penetrating gate line 115 that passes the second gap can converge the second collection gate lines 121 that are not connected to the second edge primary gate 141.

Specifically, in the embodiment shown in FIG. 13, the second discontinuous gate line 113 is adjacent to the second confluence gate line 122, the second curved gate line 114 can be disposed in the middle of the back-contact solar cell 100. The second curved gate line 114 which end bends towards the second confluence gate line 122 connects to the fourth connection section 1132 of the second discontinuous gate line 113, and both the second curved gate line 114 and the fourth connection section 1132 wrap the second collection gate line 121 adjacent to the second curved gate line 114. The second collection gate line 121 wrapped by the second curved gate line 114 is not connected to the second edge primary gate 141, but to the second confluence gate line 122 for convergence through the second penetrating gate line 115 that passes through the second gap. In such an embodiment, it can be understood that the first polar region can match the corresponding second curved gate line 114 in shape.

In addition, in some embodiments, the second curved gate line 114 can also be disposed in any other position of the back-contact solar cell 100, and single or a plurality of second curved gate lines 114 and second discontinuous gate lines 113 can be provided, which are subject to no limitations here.

### Embodiment 21

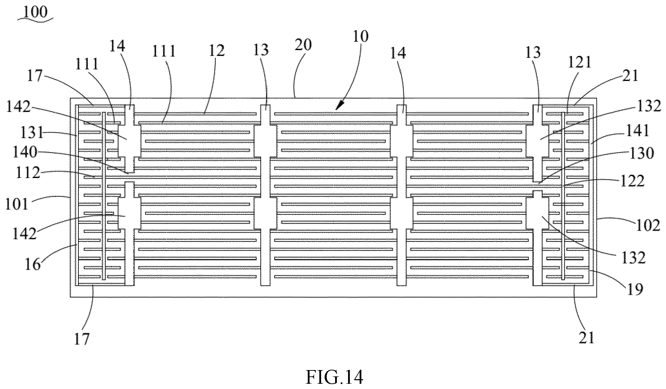

Referring to FIG. 14, in some embodiments, the electrode structure 10 may also include a second bus electrode 19 adjacent to the second edge primary gate 141, without solder joints on the second bus electrode 196. The second bus electrode 19 is closer to the second edge 102 than the second edge primary gate 141, and the second bus electrode 19 is connected to the first secondary gate 11 located between the second edge primary gate 141 and the second bus electrode 19, that is, the second bus electrode 19 has the same polarity as the first secondary gate 11 and the first primary gate 13.

The electrode structure 10 also includes a second connection gate line 21 located at the ends of the first primary gate 13 and of the second primary gate 14. The second connection gate line 21 is not disconnected at the second edge primary gate 141, and is connected to the second bus electrode 19 and the first primary gate 13 adjacent to the second edge primary gate 141.

The use of a second bus electrode 19 closer to the second edge 102 than the second edge primary gate 141 can, through the second connection gate line 19, without welding on the first bus electrode 16, converge the current collected by the first secondary gate 11 in the area near the second edge 102 to the first primary gate 11 adjacent to the second edge primary gate 141, which can avoid cracking due to stress concentration during welding at the edges, and it is not required to set the secondary gates in the edge area with the same polarity as in FIG. 3 of the background art, which may lead to poor photoelectric conversion performance.

Specifically, as shown in FIG. 14, the second bus electrode 19 has the same polarity as the first primary gate 14, and a first secondary gate 11 (i.e. the one located near the second edge 101) that is disconnected at the second edge primary gate 141 is provided between the second bus electrode 19 and the second edge primary gate 141. The second bus electrode 19 can, through the second connection gate line 21, converge the current collected by the first secondary gate 11 in the edge area to the adjacent first primary gate 13.

In further, as shown in FIG. 14, in some embodiments, two second connection gate lines 21 are located at both ends of the first primary gate 13 and of the second primary gate 14, respectively.

The two second connection gate lines 21 ensures the uniform convergence of the first secondary gates 11 in the edge area, avoiding reduced efficiency due to a long convergence path.

Specifically, as shown in FIG. 14, two second connection gate lines 21 can be connected to both ends of the second bus electrode 19 and of the adjacent first primary gate 13, that is, the second connection gate line 21, the second bus electrode 19, and the adjacent first primary gate 13 jointly enclose the second edge primary gate 141 and the secondary gate between the second edge primary gate 141 and the second bus electrode 19.

As shown in FIG. 14, in some embodiments, the spacing between the second edge primary gate 141 and the first primary gate 13 adjacent to the second edge primary gate 141 may be smaller than that between the other adjacent first primary gates 13 and the first primary gate 13, that is to say, in such a case, the first primary gates 13 and the second primary gate 14 can be arranged at uneven intervals, and the distance between the second edge primary gate 141 and the adjacent first primary gate 13 can be smaller, with or without secondary gates between them, which are subject to no restrictions here.

In some embodiments, the second bus electrode 19 is located at the second edge 102. Specifically, "the second bus electrode 19 is located at the second edge 1012" can be understood as being disposed on the edge line of the back-contact solar cell 100 or without additional secondary gates between the second bus electrode 19 and the edge line of the back-contact solar cell 100.

### Embodiment 22

In some embodiments, the width of the second connection gate lines 21 can be 80um-1.5mm.

In this way, the second connection gate lines 21 having a rational width within the range of 80um-1.5mm can ensure its convergence effect, and prevent the second connection gate lines 21 from overheating or even melting since the second connection gate lines 21 with too small width fail to withstand the current from the second bus electrode 19, and also avoid the waste of paste as a result of the second connection gate lines 21 with too large width.

Specifically, in such embodiments, the width of the second connection gate line 21 can be any one of the values from 80um, 100um, 200um, 300um, 400um, 500um, 600um, 700um, 800um, 900um, 1mm, 1.1mm, 1.2mm, 1.3mm, 1.4mm, 1.5mm, or 80um-1.5mm, which are subject to no restrictions here.

In further, in some embodiments, the width of the second connection gate line 21 may be preferably greater than 1.5 times that of the first secondary gate 11.

The second connection gate line 21 with a width greater than 1.5 times that of the first secondary gate 11 (for example, the first collection gate line 111) can ensure a better confluence effect and reliability.

Specifically, it can be understood that in the embodiment of the present application, the current that flows through the second connection gate line 21 is the converged one flowing through the second confluence gate line 122. The width of the second connection gate line 21 therefore can be preferably 1.5 times larger than that of the first secondary gate line 11, ensuring the second connection gate line 21 with a larger width and better convergence reliability.

The following Table 1 presents performance test comparison between the back-contact solar cell using the electrode pattern in FIG. 2 and 3 and the one using the electrode structure of the present application.

**Table 1**

| | Voc (mV) | Jsc (mA/cm²) | FF (%) | Conversion efficiency (%) | Efficiency loss value (%) when assuming that the edge area accounts for 10% of the total area | Remarks |
|---|---|---|---|---|---|---|
| Contrasting example 1 | 744.1 | 42.28 | 83.24 | 26.18 | | Edge welding with reliability issues |
| Contrasting example 2 | 743.8 | 30.56 | 80.48 | 18.30 | 0.788 | |
| Present application | 744.2 | 42.18 | 82.88 | 25.95 | 0.023 | |

The contrasting example 1 and 2 in Table 1 represent the technical solution using the electrode pattern in FIG.2 and FIG.3, respectively. As is well known, cell's conversion efficiency is a key performance evaluation indicator for back-contact solar cells. A higher value indicates better performance, and every 0.1% increase means a breakthrough for the industry. Table 1 reveals that the technical solution in FIG.2, although having a high efficiency, faces welding reliability at the edge which leads to a decrease in yield. The solution in FIG.3 which solves the yield and reliability of assembly, however, shows a significant reduce in the performance, with an overall conversion efficiency of only 18.3%. The efficiency loss in the edge area is up to 0.788%. The technical solution of the present application, while considering the yield and reliability of assembly, provides the overall conversion efficiency as high as 25.95%, which is much higher than the conversion efficiency in contrasting example 2. Moreover, the technical solution of the present application can reduce the efficiency loss in the edge area to 0.023%. The conversion efficiency tests of current back-contact solar cells show a repeatability of about ± 0.05%, and the efficiency loss is so low that it cannot be monitored and can be ignored.

In conclusion, the technical solution of the present application can not only address the problems of yield and reliability of the assembly, but also ensure the overall efficiency of the back-contact solar cells, while reducing the efficiency loss in the edge area.

In the description of the specification, the reference terms "some embodiments", "illustrative embodiments", "examples", "specific examples", or "some examples" refer to the specific features, structures, materials, or characteristics described in conjunction with the embodiments or examples included in at least one embodiment or example of the present application. The schematic expressions of the above terms in the specification do not necessarily refer to the same embodiments or examples. Moreover, the specific features, structures, materials, or characteristics described can be combined in an appropriate manner in any one or more embodiments or examples.

In addition, the above are only preferred embodiments of the present application that are not intended to limit the application. Any modifications, equivalent substitutions, and improvements made within the spirit and principles of the present application shall be included in the scope of protection of the present application.

## Claims

1. An electrode structure for back-contact solar cell, wherein the back-contact solar cell includes a first polar region and a second polar region which are alternatively arranged, and the electrode structure includes:
a plurality of first secondary gates and a plurality of second secondary gates, which are alternately spaced, wherein the first secondary gate electrode is used to collect the current in the first polar region, and the second secondary gate electrode is used to collect the current in the second polar region; and
a plurality of first primary gates and a plurality of second primary gates, which are alternately spaced, wherein the first and the second primary gates are arranged in a direction different from the first secondary gate and the second secondary gate; the first primary gates are connected to the first secondary gate, and the second primary gates are connected to the second secondary gates;
a plurality of first secondary gates include a first collection gate line and a first confluence gate line, wherein the first collection gate lines are disconnected at the second primary gates, and a plurality of first primary gates include a first edge primary gate located on the side near the first edge of the back-contact solar cell, and a first discontinuous zone formed by the adjacent second primary gates of the first edge primary gates; one end of the first confluence gate line is connected to the first edge primary gate, and the other end running through the first discontinuous zone is connected to the first primary gate adjacent to the first edge primary gate;
the first edge primary gate is not provided with solder joints and/or not used for welding;
the first edge primary gate is located at the first edge.

2. The electrode structure according to claim 1, wherein a plurality of first confluence gate lines and first discontinuous zones are provided, and each first discontinuous zone corresponds to at least one first confluence gate line.

3. The electrode structure according to claim 1, wherein a plurality of the first confluence gate lines are symmetrically arranged along the centerline of the back-contact solar cell in the arrangement direction of the first secondary gate and the second secondary gate; or
a single first confluence gate lines is located at the center of the back-contact solar cell.

4. The electrode structure according to claim 1, wherein the width of the first confluence gate line is 80um-1.5mm; and/or
the width of the first confluence gate line is greater than 1.5 times that of the first collection gate line.

5. The electrode structure according to claim 1, wherein a plurality of first solder joints are spaced at intervals on the second primary gate adjacent to the first edge primary gate;
the first discontinuous zone is located between two adjacent first solder joints or forms on the first solder joint.

6. The electrode structure according to claim 5, wherein the first discontinuous zone is located between two adjacent first solder joints, that is, a single first discontinuous zone is located between two adjacent first solder joints.

7. The electrode structure according to claim 5, wherein the first discontinuous zone is located between two adjacent first solder joints, and the distance between the first confluence gate line running through the first discontinuous zone and the centerline between two adjacent first solder joints is less than or equal to 20mm.

8. The electrode structure according to claim 7, wherein the distance between the first confluence gate line running through the first discontinuous zone and the centerline between two adjacent first solder joints is less than or equal to 10mm.

9. The electrode structure according to claim 8, wherein the distance between a first confluence gate line running through a first discontinuous zone and the centerline between two adjacent first solder joints is less than or equal to 5mm..

10. The electrode structure according to claim 9, wherein the distance between the first confluence gate line running through the first discontinuous zone and the centerline between two adjacent first solder joints is less than or equal to 3mm..

11. The electrode structure according to claim 1, wherein the first discontinuous zone is covered with a first insulation layer; and/or
the distance between two second secondary gates adjacent to the first confluence gate line is greater than the distance between the other adjacent second secondary gates.

12. The electrode structure according to claim 1, wherein the second secondary gate includes a first discontinuous gate line adjacent to a first confluence gate line and a first curved gate line adjacent to a first discontinuous gate line; the first discontinuous gate line includes a first connection section and a second connection section that are disposed at intervals, and a first gap is formed between the first connection section and the second connection section;
the first connection section is connected to the second primary gate adjacent to the first edge primary gate, and the second connection section is connected to the first curved gate line to encircle the end of the first collection gate line between the first discontinuous gate line and the first curved gate line; the first collection gate line located between the first discontinuous gate line and the first curved gate line is not connected to the first edge primary gate, but to the first confluence gate line through the first penetrating gate line that passes the first gap.

13. The electrode structure according to claim 1, wherein the electrode structure further includes a first confluence electrode adjacent to a first edge primary gate, and no solder joints are provided on the first confluence electrode; the first confluence electrode, which is closer to the first edge than to the first edge primary gate, is connected to the second secondary gate located between the first edge primary gate and the first confluence electrode;
the electrode structure further includes a first connection gate line located at the ends of the first primary gate and the second primary gate; the first connection gate line, which is not disconnected at the first edge primary gate, is connected to the first confluence electrode and to the second primary gate adjacent to the first edge primary gate.

14. The electrode structure according to claim 13, wherein two first connection gate lines are provided and are respectively disposed at both ends of the first primary gate and the second primary gate; and/or
the distance between the first edge primary gate and the second primary gates adjacent to the first edge primary gate is smaller than that between the other adjacent first primary gates and the second primary gates.

15. The electrode structure according to claim 13, wherein the first confluence electrode is located at the first edge.

16. The electrode structure according to claim 13, wherein the width of the first connection gate line is 80um-1.5mm; and/or
the width of the first connection gate line is greater than 1.5 times that of the second secondary gate.

17. The electrode structure according to claim 1, wherein the second primary gate includes a second edge primary gate disposed on one side near the second edge of the back-contact solar cell, and the second edge is opposite to the first edge;
a plurality of second secondary gates include a second collection gate line and a second confluence gate line; the second collection gate line, which is disconnected at the first primary gate, forms a second discontinuous zone with the first primary gate adjacent to the second edge primary gate; one end of the second confluence gate line is connected to the second edge primary gate, and the other end passes through the second discontinuous zone and is connected to the second primary gate adjacent to the second edge primary gate.

18. The electrode structure according to claim 17, wherein the second edge primary gate is not provided with solder joints and/or not used for welding; and/or
the second edge primary gate is located at the second edge of the back-contact solar cell.

19. The electrode structure according to claim 17, wherein a plurality of second confluence gate lines and second discontinuous zones are provided, and each second discontinuous zone corresponds to at least one second confluence gate line.

20. The electrode structure according to claim 17, wherein a plurality of second confluence gate lines are symmetrically disposed along the centerline of the back-contact solar cell in the arrangement direction of the first secondary gate and the second secondary gate; or
a single second confluence gate line is located at the center of the back-contact solar cell.

21. The electrode structure according to claim 17, wherein the width of the second confluence gate line is 80um-1.5mm; and/or
the width of the second collection gate line is greater than 1.5 times that of the second collection gate line.

22. The electrode structure according to claim 17, wherein a plurality of second solder joints are spaced on the first primary gate adjacent to the second edge primary gate;
Among them, the second discontinuous zone is located between two adjacent second solder joints or forms a second discontinuous zone on the second solder joint.

23. The electrode structure according to claim 22, wherein the second discontinuous zone is located between two adjacent second solder joints, and a single second discontinuous zone is disposed between the two adjacent second solder joints.

24. The electrode structure according to claim 22, wherein the second discontinuous zone is located between two adjacent second solder joints, and the distance between the second confluence gate line passing through the second discontinuous zone and the centerline between two adjacent second solder joints is less than or equal to 20mm.

25. The electrode structure according to claim 24, wherein the distance between the second confluence gate line passing through the second discontinuous zone and the centerline between two adjacent second solder joints is less than or equal to 10mm.

26. The electrode structure according to claim 25, wherein the distance between the second confluence gate line passing through the second discontinuous zone and the centerline between two adjacent second solder joints is less than or equal to 5mm.

27. The electrode structure according to claim 17, wherein the second discontinuous zone is covered with a second insulation layer; and/or
the distance between two first secondary gates adjacent to the second confluence gate line is greater than the distance between the other adjacent first secondary gates.

28. The electrode structure according to claim 17, wherein the first secondary gate includes a second discontinuous gate line adjacent to the second confluence gate line and a second curved gate line adjacent to the second discontinuous gate line; the second discontinuous gate line includes a third connection section and a fourth connection section that are spaced at intervals, and between them a second gap is formed;
the third connection section is connected to the first primary gate adjacent to the second edge primary gate, and the fourth connection section is connected to the second curved gate line to encircle the end of the second collection gate line between the second discontinuous gate line and the second curved gate line; the second collection gate line located between the second discontinuous gate line and the second curved gate line is not connected to the second edge primary gate, but to the second confluence gate line through the second penetrating gate line that passes the first gap.

29. The electrode structure according to claim 17, wherein the electrode structure further includes a second confluence electrode adjacent to the second edge primary gate, and no solder joints are provided on the second confluence electrode; the second confluence electrode, which is closer to the second edge than to the second edge primary gate, is connected to the first secondary gate located between the second edge primary gate and the second confluence electrode;
the electrode structure further includes a second connection gate line located at the ends of the first primary gate and the second primary gate; the second connection gate line is not disconnected at the second edge primary gate, and is connected to the second confluence electrode and to the first primary gate adjacent to the second edge primary gate.

30. The electrode structure according to claim 29, wherein two second connection gate lines are provided, and are respectively disposed at both ends of the first primary gate and the second primary gate; and/or
the distance between the second edge primary gate and the first primary gate adjacent to the second edge primary gate is smaller than that between the other adjacent second primary gates and the first primary gates.

31. The electrode structure according to claim 29, wherein the second confluence electrode is disposed at the second edge.

32. The electrode structure according to claim 29, wherein the width of the second connection gate line is 80um-1.5mm; and/or
The width of the second connection gate line is greater than 1.5 times that of the first secondary gate.

33. A back-contact solar cell, including an electrode structure according to any one of claims 1-32, wherein the electrode structure is disposed on the shady face of the back-contact solar cell.

34. A cell assembly, including a back-contact solar cell as claimed in claim 33.

35. A photovoltaic system, including a cell assembly as claimed in claim 34.
